# FASCICULE DE BREVET EUROPEEN

(11) **EP 2 911 987 B1**
(45) Date de publication et mention de la délivrance du brevet: **29.03.2017**
(21) Numéro de dépôt: 13795833.6
(22) Date de dépôt: 28.10.2013
(51) Int. Cl.: C03B 19/00, B32B 17/02, C03C 25/10, H01L 51/52

(54) **PROCÉDÉ DE FABRICATION DE VERRE MINCE**
VERFAHREN ZUR HERSTELLUNG DÜNNER GLASSCHEIBEN
METHOD FOR THE PRODUCTION OF THIN SHEET GLASS

(30) Priorité: 29.10.2012 FR 1260293
(43) Date de publication de la demande: 02.09.2015
(73) Titulaire: Saint-Gobain Glass France, 92400 Courbevoie (FR); Saint-Gobain Adfors, 73000 Chambéry (FR)
(72) Inventeur: GY, René, F-93140 Bondy (FR); JOANICOT, Mathieu, F-92290 Chatenay Malabry (FR); CHOULET, Anne, F-92300 Levallois (FR)
(74) Mandataire: Saint-Gobain Recherche
(86) Numéro de dépôt international: PCT/FR2013/052571
(87) Numéro de publication internationale: WO 2014/068233

(56) Documents cités:
- WO-A1-88/05031
- WO-A1-94/03657
- JP-A- S59 232 924
- US-A- 5 792 524

## Description

La présente invention concerne un nouveau procédé de fabrication de verre plat, en particulier de minces feuilles de verre comprenant un textile de verre incorporé dans une matrice de verre.

De nombreux fabricants de verre proposent depuis quelques années des verres dits « pelliculaires » ou « ultraminces » ayant une épaisseur comprise entre quelques dizaines de micromètres et environ 200 µm. Ces verres, fabriqués par procédé *float* ou *fusion draw,* sont disponibles en grand format ou sous forme de bande continue. Les plus minces sont flexibles et peuvent être enroulés. Cette flexibilité permet de les utiliser dans des procédés industriels réservés classiquement aux films et feuilles en matières plastiques, notamment dans des étapes de type déroulement-enroulement (*roll-to-roll*).

Le procédé *fusion draw* donne des verres minces, transparents, qui se distinguent par un lissé de surface exceptionnel particulièrement important dans des applications de haute technologie telles que les écrans LCD. C'est toutefois un procédé complexe, peu productif et difficile à maîtriser et le coût élevé des produits est rédhibitoire pour de nombreuses applications.

Une méthode de formation d'une plaque de verre renforcée par des fibres, par exemple de verre et par exemple sous forme de tissu est décrite dans la demande WO-A-88/05031. La présente invention propose de fabriquer un produit de remplacement des verres minces et ultraminces connus par un procédé de fabrication considérablement plus simple que le procédé *fusion draw.*

La plupart des verres minces fabriqués par le procédé de la présente invention ont une qualité optique (transparence) inférieure à celle des verres minces connus. Ils présentent toutefois une qualité de surface satisfaisante, voire équivalente à celle des verres pelliculaires. Ils sont fabriqués à partir de matières premières bon marché (textile de verre et frite de verre) disponibles en grande quantité et en différentes qualités.

L'idée à la base de la présente invention a été de mettre à profit la similitude entre les textiles de verre et les verres pelliculaires. Ces deux types de produits présentent en effet une composition chimique, une géométrie et un comportement mécanique semblables et se distinguent principalement par leur perméabilité aux fluides et leur transparence.

Le procédé de la présente invention réduit, voire supprime la perméabilité des textiles de verre aux fluides et augmente leur transparence à la lumière, les rapprochant ainsi des verres minces et ultraminces.

Pour atteindre cet objectif, on comble les ouvertures, on réduit les interfaces diffusantes et on lisse la surface d'un textile de verre en l'incorporant dans une matrice de verre résultant par exemple de la fusion d'une frite de verre appliquée sur le textile. Le textile de verre n'est pas totalement fondu ce qui garantit la bonne tenue mécanique de l'ensemble au cours de l'étape de chauffage, permettant ainsi l'application d'une force de traction uniforme et l'obtention d'une bonne planéité.

Le procédé de la présente invention se distingue par une très grande souplesse. En effet, à la fois le textile de verre et la matrice de verre peuvent être choisis indépendamment parmi un très grand nombre de produits disponibles sur le marché avec, comme seule contrainte, la nécessité d'une frite ayant une température de ramollissement inférieure à celle du textile de verre. Le procédé de la présente invention peut être mis en oeuvre avec des équipements qui demandent assez peu d'investissements lourds, ce qui représente un avantage considérable par rapport aux procédés *float* et *fusion draw.*

La présente invention a ainsi pour objet un procédé de fabrication de verre plat comprenant
(a) l'imprégnation d'un textile de verre avec une composition de verre fondu, le verre formant les fibres du textile de verre ayant une température de ramollissement supérieure à celle du verre formant la composition de verre fondu, ladite étape (a) comprenant
   (a1) l'imprégnation du textile de verre avec une composition de frite de verre, et
   (a2) le chauffage du textile de verre imprégné, obtenu à l'étape (a1), à une température supérieure à la température de ramollissement de la frite de verre,
(b) le refroidissement du textile de verre imprégné, obtenu à l'étape (a), de manière à obtenir une feuille de verre.

Dans la présente demande le terme « température de ramollissement » désigne la température dite de Littleton, également appelée point de Littleton, déterminée conformément à la norme ASTM C338. Il s'agit de la température à laquelle la viscosité d'une fibre de verre mesurée selon cette méthode est égale à 10^{6,6} Pa.s.

On entend dans la présente demande par « composition de verre fondu », une composition fluide de verre chauffée jusqu'à une température supérieure à son point de ramollissement Littleton.

Au moment de l'imprégnation du textile de verre par la composition de verre fondu, cette dernière est de préférence chauffée à une température supérieure d'au moins 100 °C, de préférence d'au moins 200 °C, à son point de ramollissement Littleton.

A l'étape (a) du procédé de l'invention le textile de verre est enduit avec une composition de frite de verre, généralement à température ambiante, et la fusion de la frite intervient seulement dans un deuxième temps.

L'étape (a) comprend donc deux étapes successives, à savoir
- une première étape (a1) d'imprégnation du textile de verre avec une composition de frite de verre, et
- une deuxième étape (a2) de chauffage du textile de verre imprégné, obtenu à l'étape (a1), à une température supérieure à la température de ramollissement de la frite de verre.

Cette mise en oeuvre de l'étape (a) permet une parfaite maîtrise des quantités de verre appliquées.

L'application de la composition de frite de verre (étape (a1)) peut se faire selon des techniques connues telles que la sérigraphie, l'enduction au moyen d'une tige filetée ou d'une racle, l'enduction par rouleaux (*roll coating*), l'enduction à travers une fente (*slot coating*).

Bien que les produits obtenus par le procédé de la présente invention soient des produits « plats » au sens où ils conservent globalement la géométrie du textile, caractérisée par deux surfaces principales parallèles l'une à l'autre, le procédé de la présente invention n'est nullement limité à des produits parfaitement plans. Les premiers essais effectués par la Demanderesse ont abouti en effet à des matériaux qui sont très satisfaisants d'un point de vue esthétique et il est tout à fait envisageable de les utiliser pour la fabrication d'objets décoratifs de formes très diverses, tels que des coupes, tubes, parois pliées ou ondulées etc.

Dans la perspective d'applications plus techniques, les produits obtenus par le procédé de la présente invention ont toutefois de préférence une forme à la fois plate et plane. Pour arriver à une planéité satisfaisante du produit final, il est indispensable de tendre le textile de verre au moins pendant l'étape de refroidissement et de préférence pendant toute la durée du procédé.

Dans un mode de réalisation préféré le textile de verre est par conséquent soumis à une force de traction selon au moins une direction dans le plan du textile de verre, pendant toute la durée de l'étape (a) et cette force de traction est de préférence maintenue, au cours de l'étape (b), au moins jusqu'à la rigidification du produit obtenu.

Cette mise sous tension du textile de verre pendant l'étape de fusion/application du verre et l'étape de refroidissement est parfaitement compatible avec et même nécessaire à la mise en oeuvre d'un procédé continu qui représente un mode de réalisation préféré de la présente invention.

Dans un tel procédé continu, le textile de verre est une bande continue et les étapes (a) et (b) sont des étapes continues mises en oeuvre d'amont en aval dans la ligne de procédé, la direction de traction étant parallèle à la direction de défilement de la bande continue de textile de verre.

Le textile de verre peut être un non-tissé ou bien un tissé. Lorsqu'il s'agit d'un tissé, le nombre de fibres de chaîne et/ou le nombre de fibres de trame est typiquement compris entre 3 et 100 par cm, de préférence entre 10 et 80 par cm.

L'objectif de la présente invention est de combler l'ensemble des trous du textile de verre. Pour atteindre ce but, il est indispensable de veiller à ce que les ouvertures du textile de départ ne soient pas trop grandes. On choisira donc de préférence des textiles de verre, tissés ou non-tissés, avec des ouvertures présentant un diamètre équivalent moyen inférieur à 1 mm, de préférence inférieur à 0,1 mm.

Le grammage des textiles de verre utilisés est généralement compris entre 50 et 500 g/m², de préférence entre 80 et 400 g/m², et en particulier entre 100 et 200 g/m².

La quantité de verre appliquée sous forme de composition de frite de verre est comprise dans l'intervalle allant de 100 à 2000 g/m², de préférence de 200 à 1500 g/m².

Cette quantité de verre peut bien entendu être appliquée en une seule fois, c'est-à-dire en une seule couche.

Dans certains cas il peut toutefois être intéressant de créer, dans la couche de verre du produit fini, un gradient de certaines propriétés, telles que l'indice de réfraction, l'indice de dilatation thermique, la densité de particules diffusantes, etc. Dans ce cas, il suffit d'appliquer successivement au cours de l'étape (a1) plusieurs couches de composition de frite de verre présentant les propriétés en question et de les faire fondre ensemble au cours de l'étape (a2).

La composition de frite de verre contient généralement de 50 à 90 % en poids, de préférence de 70 à 85 % en poids d'une poudre de verre et de 10 à 50 % en poids, de préférence de 15 à 30 % d'un liant, ou médium, formé d'un polymère organique dissous dans un solvant.

L'étape de chauffage (étape (a2)), comporte alors de préférence plusieurs paliers de température, le premier palier (100 °C - 200 °C) servant à l'évaporation du solvant, le deuxième palier (350 - 450 °C) à l'élimination du polymère organique et le troisième palier (au-delà de 550 °C) à la fusion de la frite de verre. Chaque palier de température est maintenu de préférence pendant une durée comprise entre environ 10 minutes et 1 heure, en particulier entre 15 et 30 minutes.

On peut toutefois également envisager de remplacer ce chauffage par paliers par une étape de chauffage *flash* comprenant l'augmentation de la température du textile d'au moins 600 °C en quelques secondes. Un tel chauffage flash est particulièrement intéressant dans la perspective d'un procédé industriel continu et peut se faire par exemple par une nappe laser, une rampe de torches à plasma, une rampe de brûleurs, ou par des éléments chauffants (effet joule, induction, micro-ondes).

Après fusion totale de la frite de verre, le textile de verre imprégné de verre fondu est refroidi (étape (b)). Ce refroidissement peut se faire passivement ou de manière contrôlée, par exemple par maintien du textile imprégné dans un environnement chaud. Afin de veiller à une bonne homogénéité de température tout au long de l'étape de refroidissement, il peut également être utile de chauffer certaines zones susceptibles de se refroidir plus rapidement que d'autres.

Le textile de verre chaud sortant de l'étape (a) ne vient de préférence en contact avec aucun solide ni liquide avant de s'être refroidi à une température inférieure d'au moins 50 °C, de préférence d'au moins 100 °C à la température de ramollissement du verre formant la composition de verre fondu.

Les premiers échantillons préparés par la Demanderesse se sont avérés être très diffusants. Cette forte diffusion a été attribuée, d'une part, à la différence importante entre l'indice de réfraction du verre formant le textile et celui du verre formant la frite de verre ou le bain de verre. Lorsqu'on cherche à obtenir une forte diffusivité, par exemple dans le domaine des substrats pour OLED, on veillera à ce que l'indice de réfraction du verre formant la frite de verre ou le bain de verre soit supérieur d'au moins 0,01, de préférence d'au moins 0,05 à l'indice de réfraction du textile de verre.

Par contre, lorsqu'on cherchera à augmenter le plus possible la transparence des produits finals, l'indice de réfraction du verre formant la frite de verre ou le bain de verre devra être sensiblement identique à celui du verre formant le textile de verre.

La microscopie sur des coupes transversales des produits a montré que la forte diffusivité est également due, au moins en partie, à un mouillage insuffisant des fibres de verre par le verre liquide, empêchant une pénétration satisfaisante de la matrice au coeur des fibres multi-filaments. La Demanderesse pense qu'il est possible d'atténuer, voire de surmonter, ce problème en réduisant la viscosité du verre liquide et/ou en prolongeant le temps de maintien du verre liquide à température élevée.

Le procédé selon l'invention permet d'obtenir un produit plat, ou feuille de verre, par combinaison d'un textile de verre et d'une composition de verre fondu.

Cette feuille de verre présente de préférence une épaisseur comprise entre 50 µm et 1000 µm, en particulier entre 100 µm et 800 µm.

Dans cette feuille de verre, la structure du textile de verre peut être visible par transparence à l'oeil nu. Elle peut également être masquée par un film de verre hautement diffusant, ou bien elle peut ne plus être visible du fait de la disparition des interfaces entre le matériau textile et l'émail enveloppant celui-ci.

### Exemple

Deux textiles de verre tissés présentant respectivement un grammage de 165 g/m² (A) et de 117 g/m² (B) ont été imprimés par sérigraphie avec une, deux ou trois couches d'une composition de frite de verre (environ 80 % en poids d'une poudre de verre dans 20 % d'un médium contenant du terpinéol, de l'acide acétique et de l'éthylcellulose).

Le tableau ci-dessous présente le nombre de couches de sérigraphie, le poids surfacique du textile imprégné, le poids surfacique du tissu de verre seul, le poids surfacique cumulé des couches imprimées et l'épaisseur estimée du film de verre formé après fusion de la composition de frite (densité = 2,5).

Chaque valeur indiquée est la moyenne calculée à partir de deux échantillons.

| Textile | Nombre de couches | Poids surfacique du tissu imprégné (g/m²) | Poids surfacique du tissu seul (g/m²) | Poids surfacique de la couche de verre déposée (g/m²) | Epaisseur estimée de la couche d'émail formée (µm) | Présence de trous après fusion |
|---|---|---|---|---|---|---|
| A | 1 | 600 | 165 | 435 | 174 | oui |
| | 2 | 817 | 165 | 652 | 260 | non |
| | 3 | 1006 | 165 | 841 | 336 | non |
| B | 1 | 593 | 117 | 476 | 190 | oui |
| | 2 | 793 | 117 | 676 | 270 | non |
| | 3 | 905 | 117 | 788 | 320 | non |

Les tissus ainsi imprégnés ont été soumis à un chauffage progressif avec trois paliers :
- chauffage 5°C/minute de 25 - 150 °C,
- maintien d'une température de 150 °C pendant 20 minutes,
- chauffage 5°C/minute de 150 - 430 °C,
- maintien d'une température de 430 °C pendant 20 minutes,
- chauffage 5°C/minute de 430 - 570 °C,
- maintien d'une température de 570 °C pendant 20 minutes.

On constate qu'à partir de deux couches de frite l'ensemble des trous du textile sont comblés. Les produits finaux sont globalement assez fragiles. Les produits ayant reçu deux ou trois couches de frite peuvent toutefois être manipulés sans trop de difficulté. L'ensemble des produits ont un aspect fortement diffusant, voire presque opaque.

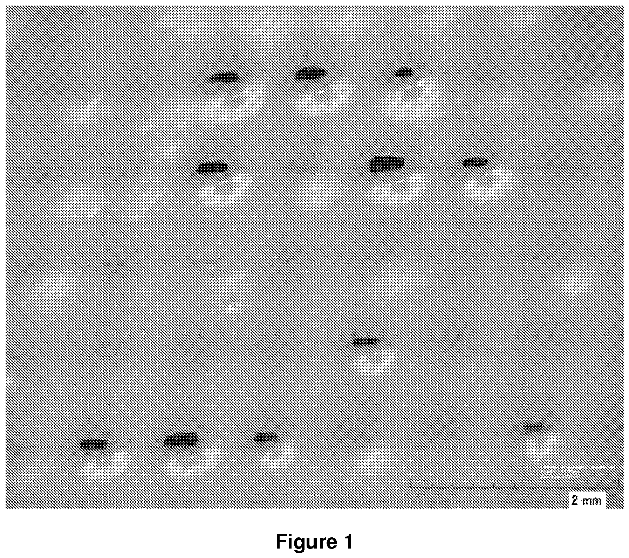

La figure 1 est une photographie sous microscope d'un textile B obtenu après impression et fusion d'une seule couche de frite. Certains trous du textile, visible par transparence, ne sont pas comblés.

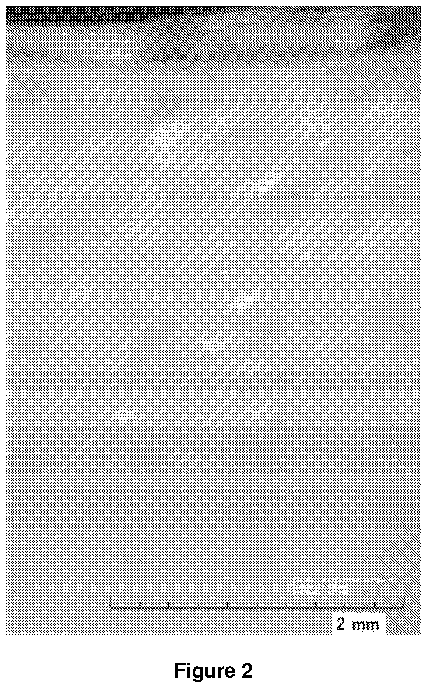

La figure 2 est un cliché d'un textile A après impression de deux couches de frite et fusion. Aucun trou n'est plus visible. L'émail a un caractère fortement diffusant. De petites bulles montées à la surface de l'émail sont visibles.

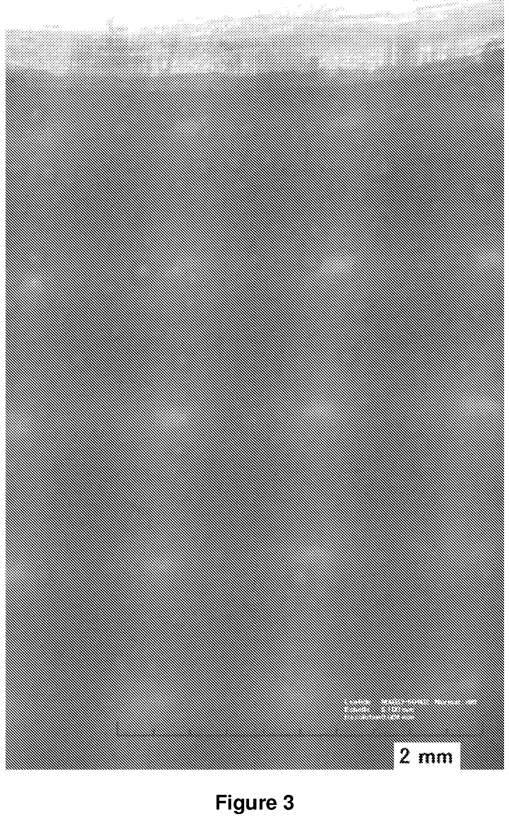

La figure 3 est un cliché du même échantillon que celui de la figure 2, éclairé par l'arrière. Cette vue par transparence confirme la présence de nombreuses bulles de gaz.

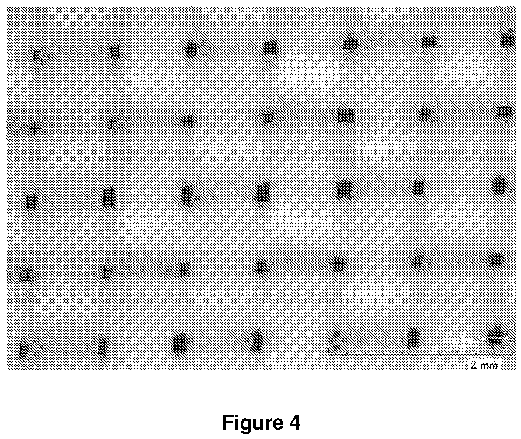

La figure 4 est une photographie du textile A dépourvu de tout dépôt d'émail.

## Revendications

1. Procédé de fabrication de verre plat comprenant
(a) l'imprégnation d'un textile de verre avec une composition fluide de verre chauffée jusqu'à une température supérieure à son point de ramollissement Littleton, le verre formant les fibres du textile de verre ayant une température de ramollissement Littleton supérieure à celle du verre formant la composition de verre fondu, ladite étape (a) comprenant
(a1) l'imprégnation du textile de verre avec une composition de frite de verre, et
(a2) le chauffage du textile de verre imprégné, obtenu à l'étape (a1), à une température supérieure à la température de ramollissement Littleton de la frite de verre,
(b) le refroidissement du textile de verre imprégné, obtenu à l'étape (a), de manière à obtenir une feuille de verre.

2. Procédé selon la revendication précédente, **caractérisé par le fait que** la température de ramollissement Littleton du verre formant les fibres du textile de verre est supérieur d'au moins 100 °C, de préférence d'au moins 200 °C, à celle du verre formant la composition de verre fondu.

3. Procédé selon la revendication 1 ou 2, **caractérisé par le fait que** l'étape (a1) est mise en oeuvre par sérigraphie, enduction au moyen d'une tige filetée ou d'une racle, enduction par rouleaux ou enduction à travers une fente.

4. Procédé selon l'une quelconque des revendications précédentes, **caractérisé par le fait que** le textile de verre est soumis à une force de traction selon au moins une direction dans le plan du textile de verre, pendant toute la durée de l'étape (a) et **par le fait que** cette force de traction est maintenue au cours de l'étape (b) au moins jusqu'à la rigidification du produit obtenu.

5. Procédé selon l'une des revendications précédentes, **caractérisé par le fait que** le textile de verre présente un grammage compris entre 50 et 500 g/m², de préférence entre 80 et 400 g/m², en particulier entre 100 et 200 g/m².

6. Procédé selon l'une quelconque des revendications précédentes, **caractérisé par** le fait la quantité de verre appliquée à l'étape (a1) sous forme de composition de frite de verre est comprise dans l'intervalle allant de 100 à 2000 g/m², de préférence de 200 à 1500 g/m².

7. Procédé selon l'une quelconque des revendications précédentes, **caractérisé par le fait que** le diamètre équivalent moyen des ouvertures du textile de verre est inférieur à 1 mm, de préférence inférieur à 0,1 mm.

8. Procédé selon l'une quelconque des revendications précédentes, **caractérisé par le fait que** le textile de verre est un tissé présentant un nombre de fibres de chaîne et/ou un nombre de fibres de trame compris entre 3 et 100 /cm, de préférence entre 10 et 80 /cm.

9. Procédé selon l'une quelconque des revendications 1 à 7, **caractérisé par le fait que** le textile de verre est un non-tissé.

10. Procédé selon l'une quelconque des revendications précédentes, **caractérisé par le fait que** le textile de verre chaud sortant de l'étape (a), ne vient en contact avec aucun solide ni liquide avant refroidissement à une température inférieure d'au moins 50 °C, de préférence d'au moins 100 °C à la température de ramollissement du verre formant la composition de verre fondu.

11. Procédé selon l'une quelconque des revendications précédentes, **caractérisé par le fait que** l'indice de réfraction du verre formant la frite de verre ou le bain de verre est sensiblement identique à celui du verre formant le textile de verre.

12. Procédé selon l'une quelconque des revendications 1 à 10, **caractérisé par le fait que** l'indice de réfraction du verre formant la frite de verre ou le bain de verre est supérieur d'au moins 0,01, de préférence d'au moins 0,05 à l'indice de réfraction du textile de verre.

## Patentansprüche

1. Verfahren zur Herstellung von Flachglas, umfassend
(a) das Imprägnieren eines Textilglases mit einer flüssigen Glaszusammensetzung, die auf eine Temperatur über ihrem Littleton-Erweichungspunkt erhitzt wird, wobei das Glas, welches die Fasern des Textilglases bildet, eine Littleton-Erweichungstemperatur aufweist, die höher als jene des Glases ist, welches die geschmolzene Glaszusammensetzung bildet, wobei der Schritt (a)
(a1) das Imprägnieren des Textilglases mit einer Glasfrittenzusammensetzung und
(a2) das Erhitzen des in Schritt (a1) erhaltenen imprägnierten Textilglases, auf eine Temperatur, die höher als die Littleton-Erweichungstemperatur der Glasfritte ist, aufweist,
(b) das Abkühlen des in Schritt (a) erhaltenen imprägnierten Textilglases, sodass man eine Glasscheibe erhält.

2. Verfahren nach dem vorhergehenden Anspruch, **dadurch gekennzeichnet, dass** die Littleton-Erweichungstemperatur des Glases, das die Fasern des Textilglases bildet, um mindestens 100 °C, vorzugsweise um mindestens 200 °C höher als jene des Glases ist, das die Zusammensetzung des geschmolzenen Glases bildet.

3. Verfahren nach Anspruch 1 oder 2, **dadurch gekennzeichnet, dass** der Schritt (a1) durch Siebdruck, Beschichten mittels einer Gewindestange oder eines Rakels, Beschichten durch Walzen oder Beschichten durch einen Schlitz durchgeführt wird.

4. Verfahren nach einem der vorhergehenden Ansprüche, **dadurch gekennzeichnet, dass** das Textilglas einer Zugkraft in mindestens einer Richtung in der Ebene des Textilglases während der gesamten Dauer des Schrittes (a) ausgesetzt wird, und dass diese Zugkraft während des Schrittes (b) mindestens bis zum Versteifen des erhaltenen Produktes beibehalten wird.

5. Verfahren nach einem der vorhergehenden Ansprüche, **dadurch gekennzeichnet, dass** das Textilglas ein Flächengewicht aufweist, das zwischen 50 und 500 g/m², vorzugsweise zwischen 80 und 400 g/m², insbesondere zwischen 100 und 200 g/m² beträgt.

6. Verfahren nach einem der vorhergehenden Ansprüche, **dadurch gekennzeichnet, dass** die Menge des Glases, die in dem Schritt (a1) in Form von einer Glasfrittenzusammensetzung aufgetragen wird, in dem Bereich von 100 bis 2.000 g/m², vorzugsweise von 200 bis 1.500 g/m² liegt.

7. Verfahren nach einem der vorhergehenden Ansprüche, **dadurch gekennzeichnet, dass** der mittlere äquivalente Durchmesser der Öffnungen des Textilglases kleiner als 1 mm, vorzugsweise kleiner als 0,1 mm ist.

8. Verfahren nach einem der vorhergehenden Ansprüche, **dadurch gekennzeichnet, dass** das Textilglas ein Gewebe ist, das eine Anzahl an Kettenfasern und/oder eine Anzahl an Schussfasern aufweist, die zwischen 3 und 100/cm, vorzugsweise zwischen 10 und 80/cm beträgt.

9. Verfahren nach einem der Ansprüche 1 bis 7, **dadurch gekennzeichnet, dass** das Textilglas ein Vlies ist.

10. Verfahren nach einem der vorhergehenden Ansprüche, **dadurch gekennzeichnet, dass** das heiße Textilglas, das aus dem Schritt (a) hervorgeht, weder mit einem Feststoff noch mit einer Flüssigkeit in Kontakt kommt vor dem Abkühlen auf eine Temperatur, die um mindestens 50 °C, vorzugsweise um mindestens 100 °C niedriger als die Erweichungstemperatur des Glases ist, das die Zusammensetzung des geschmolzenen Glases bildet.

11. Verfahren nach einem der vorhergehenden Ansprüche, **dadurch gekennzeichnet, dass** der Brechungsindex des Glases, das die Glasfritte oder das Glasbad bildet, im Wesentlichen mit jenem des Glases identisch ist, das das Textilglas bildet.

12. Verfahren nach einem der vorhergehenden Ansprüche 1 bis 10, **dadurch gekennzeichnet, dass** der Brechungsindex des Glases, das die Glasfritte oder das Glasbad bildet, um mindestens 0,01, vorzugsweise um mindestens 0,05 höher als der Brechungsindex des Textilglases ist.

## Claims

1. A process for manufacturing flat glass, comprising:
(a) impregnating a glass textile with a molten glass composition heated to a temperature above the Littleton softening temperature of the composition, the glass forming the fibers of the glass textile having a Littleton softening temperature above that of the glass forming the molten glass composition, said step (a) comprising
(a1) impregnating the glass textile with a glass frit composition, and
(a2) heating the impregnated glass textile, obtained in step (a1), to a temperature above the Littleton softening temperature of the glass frit; and
(b) cooling the impregnated glass textile, obtained in step (a), so as to obtain a glass sheet.

2. The process as claimed in the preceding claim, **characterized in that** the Littleton softening temperature of the glass forming the fibers of the glass textile is above, by at least 100°C and preferably by at least 200°C, that of the glass forming the molten glass composition.

3. The process as claimed in either of claims 1 and 2, **characterized in that** step (a1) is carried out by screen printing, coating by means of a threaded rod or a doctor blade, roll coating or slot coating.

4. The process as claimed in any one of the preceding claims, **characterized in that** the glass textile is subjected to a tensile force in at least one direction in the plane of the glass textile, throughout step (a), and **in that** this tensile force is maintained during step (b) at least until the product obtained has stiffened.

5. The process as claimed in one of the preceding claims, **characterized in that** the glass textile has a weight per unit area comprised between 50 and 500 g/m², preferably between 80 and 400g/m², in particular between 100 and 200 g/m².

6. The process as claimed in any one of the preceding claims, **characterized in that** the amount of glass applied in step (a1) in the form of the glass frit composition is comprised in the interval ranging from 100 to 2000 g/m², and preferably from 200 to 1500 g/m².

7. The process as claimed in any one of the preceding claims, **characterized in that** the average equivalent diameter of the apertures of the glass textile is smaller than 1 mm, and preferably smaller than 0.1 mm.

8. The process as claimed in any one of the preceding claims, **characterized in that** the glass textile is a woven having a number of warp threads and/or a number of weft threads comprised between 3 and 100 /cm, and preferably between 10 and 80 /cm.

9. The process as claimed in any one of claims 1 to 7, **characterized in that** the glass textile is a nonwoven.

10. The process as claimed in any one of the preceding claims, **characterized in that** the hot glass textile obtained in step (a) does not make contact with any solids or liquids before cooling to a temperature below, by at least 50°C and preferably by at least 100°C, the softening temperature of the glass forming the molten glass composition.

11. The process as claimed in any one of the preceding claims, **characterized in that** the refractive index of the glass forming the glass frit or the glass bath is substantially identical to that of the glass forming the glass textile.

12. The process as claimed in any one of claims 1 to 10, **characterized in that** the refractive index of the glass forming the glass frit or the glass bath is higher, by at least 0.01 and preferably by at least 0.05, than the refractive index of the glass textile.
